# EUROPEAN PATENT SPECIFICATION

(11) **EP 3 207 383 B1**
(45) Date of publication and mention of the grant of the patent: **08.07.2020**
(21) Application number: 15795119.5
(22) Date of filing: 15.10.2015
(51) Int. Cl.: H01Q 3/02, H01Q 3/34, H01Q 3/36, G01R 29/10, H04B 17/00

(54) **A TEST APPARATUS AND A METHOD OF TESTING OF AN ANTENNA**
TESTVORRICHTUNG UND VERFAHREN ZUM TESTEN EINER ANTENNE
APPAREIL D'ESSAI ET PROCÉDÉ D'ESSAI D'UNE ANTENNE

(30) Priority: 16.10.2014 GB 201418334
(43) Date of publication of application: 23.08.2017
(73) Proprietor: Telefonaktiebolaget LM ERICSSON (PUBL), 16483 Stockholm (SE)
(72) Inventor: GÖTTL, Maximilian, 83004 Rosenheim (DE); STEINHAUSER, Karl-August, 83004 Rosenheim (DE)
(74) Representative: Harrison, Robert John
(86) International application number: PCT/EP2015/073843
(87) International publication number: WO 2016/059140

(56) References cited:
- US-A- 5 270 723
- US-A- 5 721 554
- US-B1- 7 119 739

## Description

### Field of the Invention

The disclosure relates to a test apparatus for the testing of an antenna and a method for the testing of an antenna in the test apparatus.

### Background to the Invention

There are a number of methods known for the measurement of a radiation pattern and for testing of antennas for mobile communications.

Far-field measurements of the antenna being tested can also be carried out in the open air. These measurements, however, require the distance between the antenna being tested and the detector to be at a significant distance to eliminate near-field effects. For example, the measurement of a mobile communication antenna having a length of 2.6 m at 1 GHz requires the detector to be at a distance of 45 m from the antenna being tested. The measurements in the open air are affected by reflections from nearby bodies and also possibly interference from other mobile communication antennas operating at neighbouring frequencies.

It is possible to use a shielded measurement anechoic chamber in order to measure the near-field radiation pattern of the antenna and then calculate the far-field radiation pattern. These measurement chambers do not require as much space as far-field measurements. The measurement chamber can be, for example, around 10 m in size. The value of the field as well as the phase is measured over the solid angle surrounding the antenna (or at least a substantial part of the solid field) and it is then possible to calculate the far-field radiation pattern of the antenna being tested from this receiving pattern. This calculation requires knowledge of the phase of the radiation being measured, which is generally available for passive antennas. However, knowledge of the phase is generally not available for active antennas. These measurements can also require a significant amount of time to perform.

A further apparatus for measuring the radiation pattern of the test antenna is a so-called compact range chamber. The compact range chamber uses the spherical field from a feed antenna and directs the field using one or more curved mirrors in order to create a far-field with substantially parallel wave fronts at the test antenna. The test antenna is placed in this far-field in the so-called quiet zone where the wave front is substantially planar. The compact range chamber enables the direct measurement of the far-field but requires a measurement chamber that is larger than that for measuring a near-field. This is because the curved mirrors used in the measurement chamber require a dimension that is at least twice as large as the test antenna. For example, a 2.6 m mobile communications antenna requires a curved mirror having around 5 m diameter. Such a compact range chamber has the further disadvantage that the direct beam between the feed antenna and the test antenna can disturb the measurements. It would be possible to build a compact range chamber that produces a cylindrical wave in the measurement zone. These compact range chambers are, however, substantially more difficult to construct. It would also be possible to use lenses instead of curved mirrors to produce the far-field.

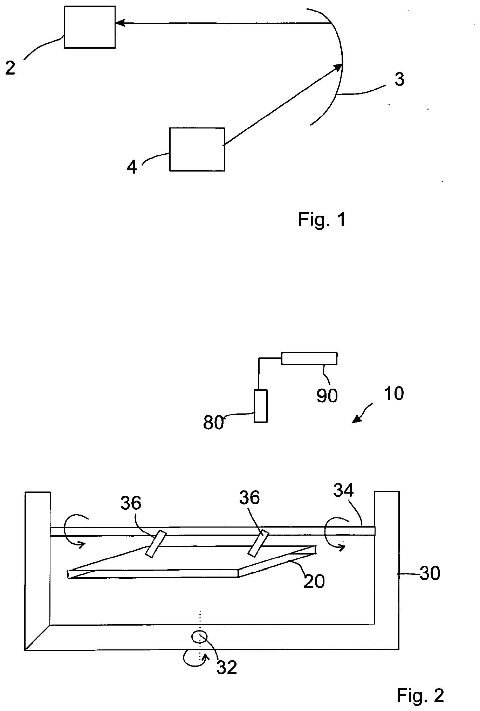

Fig. 1 shows an arrangement for testing a test antenna 2 according to the prior art. A feed antenna 4 is oriented towards a reflector 3, the shape of which is designed to reflect the spherical wave in an approximately planar manner. Fig. 2 shows an example of an antenna 20 under test of which the radiation pattern is to be measured. The antenna 20 is mounted in a so-called quiet zone of an anechoic test apparatus 10 on a measurement stand 30, which comprises a rotatable horizontal axis 34 to which the antenna 20 is attached by struts 36. The antenna 20 can be rotated 360° about the horizontal axis 34, as indicated by the arrows. This enables the antenna 20 to be tested in all directions. The measurement stand 30 is further connected to a vertical axis 32 to enable the measurement stand 30 to be rotated in a direction substantially perpendicular to the plane of the floor of the test apparatus 10, as indicated by the arrow. The combination of the rotation of the vertical axis 32 and the horizontal axis 34 enables the radiation pattern of the antenna 20 to be measured in all spatial directions.

A probe or detector 80 measures the radiation pattern from the antenna 20. The probe 80 is connected to a measurement apparatus 90, which is able to calculate the radiation pattern from the measurements. The distance between the probe 80 and the antenna 20 under test is chosen to be sufficiently large that reflections do not affect the result.

Chinese Patent Application No. 102854401 teaches a method for measuring the radiation pattern from an antenna array under test. The method comprises measuring the radiation patterns of the antenna array by irradiating the antenna array from different angles by uniform plane waves. The response of the antenna array under the irradiation of the plane waves is measured by a digital oscilloscope. The responses are normalized to obtain the radiation patterns of the antenna array under the conditions of uniform amplitude and co-phase excitation and the radiation pattern can be calculated through digital signal processing technology and a superposition principle of the patterns of the array antenna unit.

Japanese Patent Application No. JP 2012-117959 (Mitsubishi Electric) teaches an antenna measurement method, which comprises generation of a radio frequency signal (RF) followed by changing an amplitude and a phase of the high frequency signal corresponding to an element antenna to be a measured. The RF signal is sent from a plurality of antenna elements and the resulting RF signal is received at the antenna being measured. Document US 5 270 723 teaches a method and an apparatus for near field antenna measurements.

### Summary of the Invention

A measurement apparatus for the measurement of a test antenna according to the invention is disclosed in claim 1 and a method is disclosed in claim 8. A feed antenna is mounted in the measurement apparatus and comprises a plurality of radiating elements. The test antenna is placed on a moveable stand, at a predefined test distance from the feed antenna. The feed antenna is fed using an antenna feed system, having a plurality of adjustment components for adjusting the phase and amplitude of a wave front from a plurality of radiating elements. The plurality of adjustment components adjusts the phase and amplitude of the wave front from the feed antenna such that the wave front is substantially planar at said predefined test distance.

The adjustment of the phase and amplitude of test signals from the feed antenna enables a substantially parallel wave front to be created at the predefined test distance. In other words, a quiet zone is created at the location at which the radiation pattern of the test antenna is measured. This measurement apparatus does not require a mirror in order to direct the wave front such that the wave front is substantially parallel at the antenna being tested. The use of the plurality of radiation elements, which could be placed in groups, enables the wavefront to be controlled.

The test antenna is placed at the predefined test distance corresponding to the quiet zone of the feed antenna. The position of this quiet zone depends on the phase and amplitude settings of the feed antenna and can therefore be adjusted to different requirements, which include a size of the test antenna, a size of the feed antenna, a sufficient distance between the test antenna and the feed antenna to reduce signals corrupted by multiple paths reflected between the test antenna and the feed antenna, and a small distance to fit into an anechoic chamber. The phase and amplitude settings of the feed antenna may be adjusted to generate a large quiet zone. A non-limiting example could be, e.g. for a frequency of 1 -2 GHz, a feed antenna length of 4 m, a test antenna length of 2 m, the predefined test distance between the test antenna and the feed antenna could be a distance of 4m. The phase and amplitude settings can be adjusted during the design of measurement apparatus. The phase and amplitude settings can be adjusted depending on the test antenna to be tested.

The test antenna is placed on a moveable stand, which is rotatable around at least one axis. In a preferred embodiment the stand can be rotated about two axes. One of the two axis is a substantially vertical axis and the other one of the two axes is a substantially horizontal axis. This allows the test antenna to be moved in three dimensions such that the radiation pattern from the test antenna can be measured in all of the spatial angle.

The antenna feed system has delay elements and/or attenuators connected between the individual ones of the radiating elements and the feed system. In one aspect of the invention, the delay elements are hard-wired lengths of coaxial cable, which are cut to the required length. It would be possible to replace the hard-wired delay elements with software adjustments. The plurality of radiation elements can produce cross-polarised beams. In one aspect of this disclosure, orthogonal polarisations are used.

The disclosure also teaches a method according to claim 8. The method for the testing of a test antenna in a measurement apparatus comprises: placing the test antenna at a movable stand of the measurement apparatus; adjusting at least one of phase, delay and amplitude of a wave front from a feed antenna comprising a plurality of radiating elements, to detect a substantially planar wave front at the movable stand, using a plurality of adjustment components for adjusting at least one of phase or delay; emitting a test signal by the test antenna and receiving the test signal at the feed antenna, moving the movable stand and repeating the step of emitting and receiving to derive a radiation or transmission pattern of the test antenna.

The disclosure also teaches a method for the testing of a test antenna in a measurement apparatus comprising: placing the test antenna at a movable stand of the measurement apparatus; adjusting at least one of a phase, delay and amplitude of a plurality of radiating elements, forming a feed antenna, to produce a substantially planar wave front at the movable stand, using a plurality of adjustment components for adjusting said at least one of a phase, delay and amplitude; emitting a test signal by a feed antenna and receiving the test signal by the test antenna, moving the movable stand and repeating the step of emitting and receiving to derive a reception pattern of the test antenna.

When the test antenna is an active antenna, both the reception pattern and the transmission pattern of the active antenna should be tested.

In one aspect of this disclosure, the test signal is generated with at least two orthogonal polarisations. The two orthogonal polarisations enable the testing of test antennas with arbitrary polarisation.

The method provides a way to measure the far-field radiation pattern of the antenna under test without the need to test in the open air or to convert measurements mathematically from near-field measurements. Therefore this method can be used in a compact measurement setup for both passive and active antennas.

### Description of the Figures

Fig. 1 shows an example of an apparatus for measuring a test antenna according to the state of the art;
Fig. 2 shows an example of antenna mounted on a measurement stand in a measurement apparatus according to fig.1.
Fig. 3 shows an overview of the measurement apparatus with an antenna feed system according to the present disclosure.
Fig. 4 shows an example of antenna mounted on a measurement stand in a measurement apparatus according to fig.3
Fig. 5 shows a measurement of the power distribution of a signal generated by a feed antenna according to one aspect of the disclosure.
Fig. 6 shows a calculation of a power distribution across the radiating elements in a feed antenna according to one aspect of the disclosure
Fig. 7 shows a calculation of the length of the delay elements in the feed system according to one aspect of the disclosure.
Fig. 8 shows a method of testing a test antenna according to one aspect of the disclosure;
Fig. 9 shows a method of testing a test antenna according to yet another aspect of the disclosure.

### Detailed Description of the Invention

The invention will now be described on the basis of the drawings. It will be understood that the embodiments and aspects of the invention described herein are only examples and do not limit the protective scope of the claims in any way. The invention is defined by the claims and their references. It will be understood that features of one aspect or embodiment of the invention can be combined with a feature of a different aspects or aspects and/or embodiments of the invention.

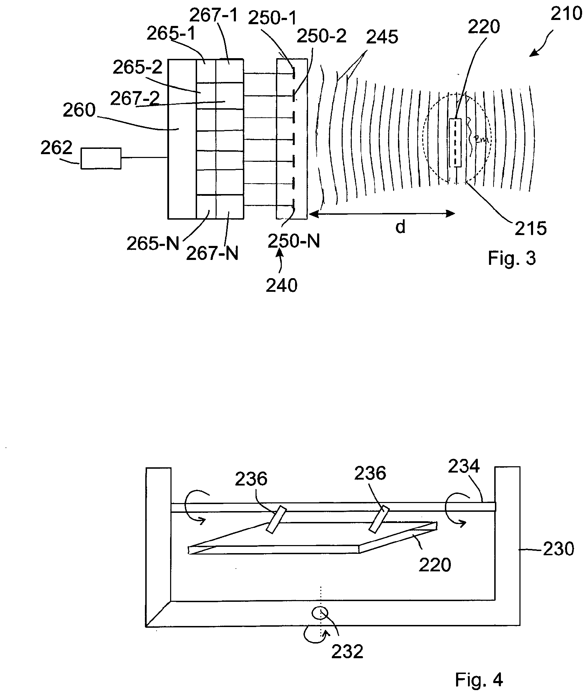

Fig. 3 shows an overview, from above, of a test apparatus 210 according to an aspect of the disclosure for testing a test antenna 220. Fig. 4 shows an example of a test antenna 220 of which the radiation pattern is to be measured. The test apparatus 210 has a feed antenna 240 with a plurality of radiating elements 250-1, 250-2, ..., 250-N. The plurality of radiating elements 250-1, 250-2, ..., 250-N is connected to a feed system 260. The feed system 260 is connected to a test signal generator and receiver 262 adapted to generate and/or receive a test signal.

The feed system 260 can be used for feeding test signal in a frequency domain in which the test antenna 220 is to be tested. The feed system 260 may further comprise two feed sub-systems for operating the feed antenna 240 in two frequency domains, e.g. in a first frequency range between 700 MHz and 960 MHz and in a second frequency range between 1710 MHz and 2690 MHz. This enables the use of the feed antenna 240 for testing other test antennas in different frequency ranges.

A plurality of delay elements or phase shifters 265-1, 265-2, ..., 265-N are present in the antenna feed system 260 which delay the test signal received from the test signal generator 262 which is sent to the feed antenna 240. A plurality of attenuators 267-1, 267-2,..., 267-N is also present in the antenna feed system 260 which are adapted to adjust the amplitude of the radiating elements 250-1, 250-2, ..., 250-N.

The purpose of the delay elements 265-1, 265-2, ..., 265-N and the attenuators 267-1, 267-2,..., 267-N is to produce a test signal at the radiating elements 250-1, 250-2, ..., 250-N, which produces at a predefined test distance a planar wave front, as shown on Fig. 3. In other words, a test signal is produced that substantially approximates a far-field pattern at the predefined test distance d without the need for the curved mirrors of the prior art.

The plurality of radiating elements 250-1, 250-2, ..., 250-N are dipoles having two polarisation components, such as vertical or horizontal components, or cross-polarised components (-45°, +45°). Any polarisation could be used. The polarisation components are orthogonal in one aspect of this disclosure.

The radiating elements 250-1, 250-2, ..., 250-N are shown mounted linearly in Fig. 3. It would be possible to construct a two-dimensional array of the radiating elements 250-1, 250-2, ..., 250-N to produce a three dimensional field in the quiet zone.

The feed antenna 240 comprises between 15 and 30 radiating elements (N is in the range of 15-30). It should be noted that the number of radiating elements depends among other on the frequency.

The delay elements 265 can be hard-wired and made, for example, from cut lengths of coaxial cable. It would also be possible to use a software-generated test signal without the delay elements 265 to generate the test pattern.

Fig. 4 shows an example of a test antenna 220 of which the radiation pattern is to be measured. The antenna 220 is mounted on a measurement stand 230, at the predefined test distance d, i.e. where the wave front is substantially planar. In other words, the measurement stand is placed in a quiet zone 215.

The measurement stand 230 comprises a rotatable horizontal axis 234 to which the antenna 220 is attached by struts 236. The test antenna 220 can be rotated 360° about the horizontal axis 234, as indicated by the arrows. This enables the test antenna 220 to be tested in all directions. The test antenna 220 can be either an active antenna or a passive antenna.

The measurement stand 230 is further connected to a vertical axis 232 to enable the measurement stand 230 to be rotated in a direction substantially perpendicular to the plane of the floor of the test apparatus 210, as indicated by the arrow. The combination of the rotation of the vertical axis 232 and the horizontal axis 234 enables the radiation pattern of the test antenna 220 to be measured in all spatial directions.

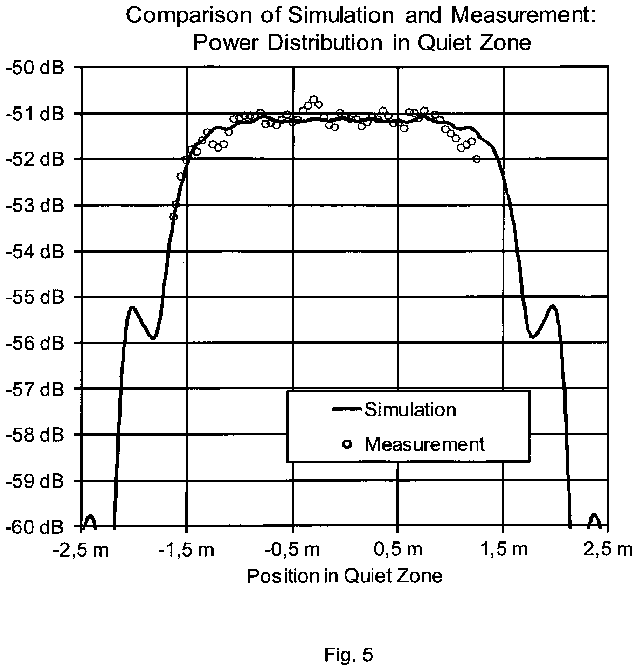

Fig. 5 shows a measurement of the power distribution signal generated by the feed antenna 240 at the predefined test distance d, e.g. in the quiet zone, across the length of the antenna 220, which is approximately 2,5 meters. It will be seen that, at a frequency of 2.35 GHz, the RF field in the quiet zone is substantially uniform across the length of the antenna 220. There is a small drop-off of the power at the edges of the quiet zone, as might be expected.

At least ten radiating elements are needed to generate a planar wavefront at said predefined distance less than 4 meters. In one aspect of the disclosure, 15 to 30 radiating elements are provided to provide a more uniform planar wavefront, but this is not limiting of the invention. It should be noted that the number of radiating elements depends among other on the frequency.

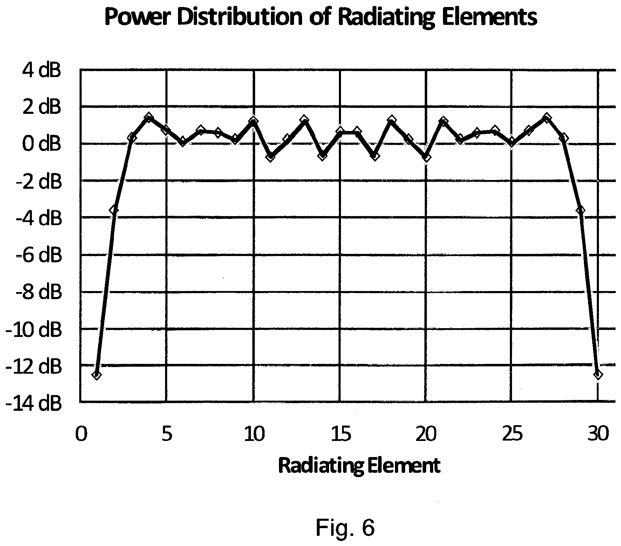

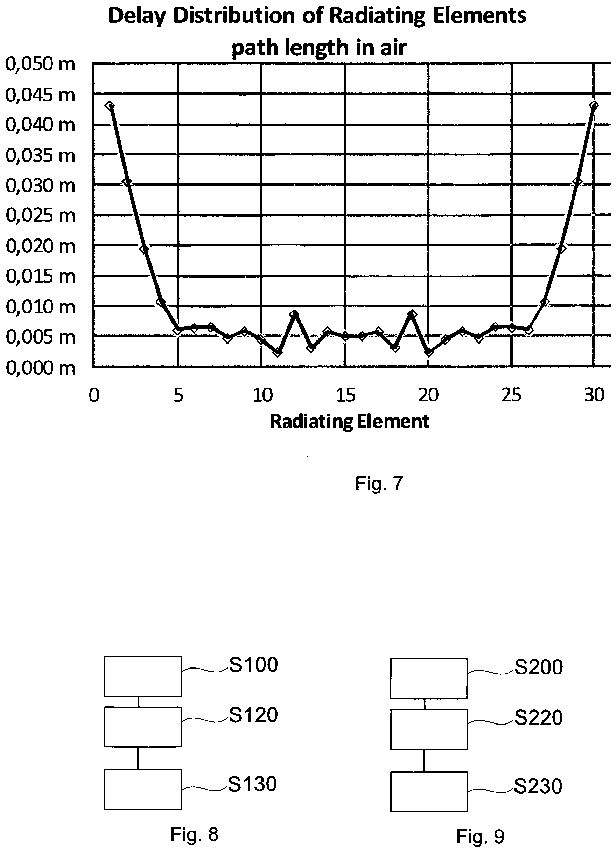

Fig. 6 shows a calculation of a power distribution across the radiating elements in a feed antenna according to one aspect of the disclosure. It will be seen that the best performance of the quiet zone is achieved, when the power distribution set by the attenuators 267-1, 267-2,..., 267-N is almost constant in the centre of the feed antenna 240 and with a reduced power at the edges of the feed antenna 240. Fig. 7 shows a calculation of delays introduced by the delay elements 265-1, 265-2, ..., 265-N in the antenna feed system 260. It will be seen that a delay needs to be introduced such that the radiation of the test signal from the radiating elements 250-1, 250-2,..., 250-N, at the edges of the feed antenna 240 is slightly delayed with respect to the test signal from the radiating elements 250-1, 250-2,..., 250-N, at the centre of the feed antenna 240. In other words, a best approximation of a plane wave at the predefined test distance can be achieved with almost no delay of the signal fed to the centre radiating elements of the feed antenna 240 and with a slight positive delay of the signal fed to the radiating elements at the edge of the feed antenna 240.

It should be noted that the phase, delay and/or amplitude of the radiating elements may be adjusted individually for each radiating element of the plurality of radiating elements. Alternatively, the phase, delay and/or amplitude of the radiating elements may be adjusted for groups of radiating elements of the plurality of radiating elements, each the radiating elements of a group have the same phase, delay and/or amplitude.

Tests have shown that the results obtained from measuring the radiation pattern from the test antenna 220 in the measurement apparatus 210, as described in this disclosure, are as good as those in the field and those performed in a compact range apparatus. The far-field is used and therefore there is no need to perform a mathematical transformation from measurement of the near-field, which would require anyway knowledge of the phase information of the measured data.

Fig. 8 shows a method for the testing of a test antenna in a measurement apparatus 210. The method is described with reference to the measurement apparatus 210 of figures 2-3.

The test antenna 220 is placed at the movable measurement stand 230 (Step S100).

The phase, delay and/or amplitude for the plurality of radiating elements 250-1, 250-2, ..., 250-N is adjusted to produce a substantially planar wave front at the movable stand 230 (step S120). It should be noted that the adjustment of the phase, delay and/or amplitude for the plurality of radiating elements 250-1, 250-2, ..., 250-N may be performed at the time of designing and manufacturing the feed antenna 240. It is also possible to adjust the phase, delay and/or amplitude for the plurality of radiating elements 250-1, 250-2, ..., 250-N depending on the test antenna to be tested.

The test antenna is placed at the predefined test distance corresponding to the quiet zone of the feed antenna. The position of this quiet zone depends on the phase and amplitude settings of the feed antenna and can therefore be adjusted to different requirements, which include a size of the test antenna, a size of the feed antenna, a sufficient distance between the test antenna and the feed antenna to reduce signals corrupted by multiple paths reflected between the test antenna and the feed antenna, and a small distance to fit into an anechoic chamber. The phase and amplitude settings of the feed antenna 240 may be adjusted to generate a large quiet zone or a smaller quiet zone with a high intensity. For example, for a frequency in the range of 1 to 2 GHz, a feed antenna length of 4 m, a test antenna length of 2 m, the predefined test distance between the test antenna and the feed antenna could be a distance of 4m.

A test signal is emitted by the feed antenna 240 and the test signal is received by the test antenna 220 to derive a radiation pattern of the test antenna 220. The test antenna 220 receives a substantially planar wave front (Step S130).

The antenna 220 is rotated about the horizontal axis 234 and/or about the vertical axis 232.

As noted above, the test signal is generated with at least one of two orthogonal polarisation, for example a horizontal and a vertical polarisation. It should be noted that the test signal could be generated with two non-orthogonal polarisations as well. The provision of two orthogonal polarisations enables accurate measurements.

Fig. 9 shows another method for the testing of a test antenna in a measurement apparatus 210. The method is described with reference to the measurement apparatus 210 of figures 2-3.

The test antenna 220 is placed at the movable measurement stand 230 (Step S200).

The phase, delay and/or amplitude for the plurality of radiating elements 250-1, 250-2,..., 250-N is adjusted to produce a substantially parallel wave front at the movable stand 230 (step S220). It should be noted that the adjustment of the phase, delay and/or amplitude for the plurality of radiating elements 250-1, 250-2, ..., 250-N may be performed at the time of designing and manufacturing the feed antenna 240. It is also possible to adjust the phase, delay and/or amplitude for the plurality of radiating elements 250-1, 250-2, ..., 250-N depending on the test antenna to be tested.

The test antenna 220 emits the test signal, which is received by the feed antenna 240 working in reception or receive mode (step S230). This step is repeated for different positions of the movable stand, thus of the test antenna 220.

The test apparatus 210 and measurement system of this disclosure are substantially cheaper to construct than creating a curved mirror as required in previous systems.

A further aspect of the invention is the placement of the radiating elements 250-1, 250-2,..., 250-N in an angular manner, such as on sidewalls of the measurement apparatus 210.

In a further aspect of the invention the dipoles of the radiating elements 250-1, 250-2, ..., 250-N are connected to test the response of the test antenna 220 in other polarisation directions. This is done by a Butler matrix for passive antennas and digitally for active antennas.

It would also be possible to feed test signals of two different frequencies to the radiating elements . This will require two different antenna feed systems 260 or a feed system 260 constructed from active components.

### Reference Numerals

10, 210 Measurement apparatus
15,215 Quiet zone
20, 220 test Antenna
30, 230 Measurement stand
32, 232 Vertical axis
34, 234 Horizontal axis
36,236 Struts
40, 240 Feed antenna
245 Wave front
250-1, 250-2, ..., 250-N Radiating elements
260 Antenna feed system
262 Test signal generator and receiver
265-1, 265-2, 265-N Delay elements
265-1, 265-2, 265-N Attenuator elements
270 Measurement box
80 Probe
90 Measurement device

## Claims

1. A measurement apparatus (210) for the measurement of a test antenna (220) comprising:
a movable stand (230) for supporting the test antenna (220),
a feed antenna (240) having a plurality of radiating elements (250-1, 250-2, ..., 250-N),
wherein the movable stand (230) is located at a predefined distance (d) from the feed antenna (240); and
an antenna feed system (260) having a plurality of adjustment components for adjusting the phase and amplitude of a wave front (245) from the plurality of radiating elements (250-1, 250-2, ..., 250-N), such that at the distance (d) the wave front is planar,
the plurality of radiating elements (250-1, 250-2, ..., 250-N) comprise at least a pair of radiating elements (250-1, 250-2, ..., 250-N) for producing orthogonal polarisation components,
the antenna feed system (260) has a plurality of attenuators or gain elements (267-1, 267-2, ..., 267-N) connected to the radiating elements (250), for adjusting the amplitude of the wave front (245) from the plurality of radiating elements (250-1, 250-2, ..., 250-N), the antenna feed system (260) being configured to adjust a power distribution set by the plurality of attenuators or gain elements (267-1, 267-2, ..., 267-N) such that a power is constant at least in a center portion of the feed antenna (240) and is reduced at an edge of the feed antenna (240), wherein the feed antenna (240) comprises between 15 and 30 radiating elements.

2. The measurement apparatus (210) of claim 1, wherein the movable stand (230) is rotatable around at least one axis (232, 234).

3. The measurement apparatus (210) of claim 2, wherein the at least one axis (232, 234) is one of a vertical axis (232) or a horizontal axis (234).

4. The measurement apparatus (210) of any of the above claims, wherein the antenna feed system (260) has at least one of a plurality of phase element or delay elements (265-1, 265-2, ..., 265-N) connected to the radiating elements (250-1, 250-2, ..., 250-N), for adjusting the phase of the wave front (45) from the plurality of radiating elements (250-1, 250-2, ..., 250-N).

5. The measurement apparatus (210) of any of the above claims, whereby the plurality of radiating elements is arranged in a linear array.

6. The measurement apparatus (210) of any of the above claims, whereby the plurality of radiating elements is arranged in a two-dimensional array.

7. The measurement apparatus (210) of any of the above claims, wherein the feed antenna (240) is about twice as large as the test antenna (220).

8. A method for the testing of a test antenna (220) in a measurement apparatus (210) comprising:
placing the test antenna (220) at a movable stand of the measurement apparatus (210);
adjusting a phase and amplitude of a plurality of radiating elements (250-1, 250-2, ..., 250-N) forming a feed antenna (240), to produce a planar wave front (245) at the movable stand,
using a plurality of adjustment components for adjusting said phase and amplitude, wherein the feed antenna (240) comprises between 15 and 30 radiating elements;
emitting a test signal by the feed antenna (240) and
receiving the test signal by the test antenna, to derive a reception pattern of the test antenna (220); and
repeating the steps of emitting the test signal and receiving the test signal for different positions of the movable stand;
wherein ones of the plurality of radiating elements (250-1, 250-2, ..., 250-N) comprise at least a pair of radiating elements (250-1, 250-2, ..., 250-N) for producing orthogonal polarisation components,
the method further comprising adjusting, by a plurality of attenuators or gain elements (267-1, 267-2, ..., 267-N) connected to the radiating elements (250), the amplitude of the wave front (245) from the plurality of radiating elements (250-1, 250-2, ..., 250-N), whereby the adjusting comprises adjusting a power distribution set by the plurality of attenuators or gain elements (267-1, 267-2, ..., 267-N) such that a power is constant at least in a center portion of the feed antenna (240) and is reduced at an edge of the feed antenna (240).

9. The method of claim 8, further comprising rotating the test antenna (220) about a horizontal axis (234) and/or about a vertical axis (232).

10. The method of any one of claims 8 and 9, further comprising setting a same first one of at least one of phase, delay and amplitude for a first group of radiating elements and a same second one of at least one of phase, delay and amplitude for a second group of radiating elements.

## Patentansprüche

1. Messvorrichtung (210) zur Messung einer Testantenne (220) umfassend:
einen beweglichen Ständer (230) zum Stützen der Testantenne (220),
eine Speiseantenne (240) mit einer Vielzahl von Strahlerelementen (250-1, 250-2, ..., 250-N),
wobei der bewegliche Ständer (230) angeordnet ist in einem vorbestimmten Abstand (d) von der Speiseantenne (240); und
ein Antennenspeisesystem (260) mit einer Vielzahl von Einstellkomponenten zum Einstellen der Phase und Amplitude einer Wellenfront (245) aus der Vielzahl von Strahlerelementen (250-1, 250-2, ..., 250-N), so dass die Wellenfront in dem Abstand (d) planar ist,
die Vielzahl von Strahlerelementen (250-1, 250-2, ..., 250-N) umfasst mindestens ein Paar von Strahlerelementen (250-1, 250-2, ..., 250-N) zum Erzeugen von orthogonalen Polarisationskomponenten,
das Antennenspeisesystem (260) weist eine Vielzahl von Abschwächern oder Verstärkungselementen (267-1, 267-2, ...., 267-N) auf, die mit den Strahlerelementen (250) verbunden sind, um die Amplitude der Wellenfront (245) aus der Vielzahl von Strahlerelementen (250-1, 250-2, ..., 250-N) einzustellen, wobei das Antennenspeisesystem (260) ausgestaltet ist, um eine durch die Vielzahl von Abschwächern oder Verstärkungselementen (267-1, 267-2, ..., 267-N) eingestellte Leistungsverteilung so einzustellen, dass eine Leistung zumindest in einem mittleren Abschnitt der Speiseantenne (240) konstant ist und an einem Rand der Speiseantenne (240) reduziert wird, wobei die Speiseantenne (240) zwischen 15 und 30 Strahlerelemente umfasst.

2. Messvorrichtung (210) nach Anspruch 1, bei welcher der bewegliche Ständer (230) um mindestens eine Achse (232, 234) drehbar ist.

3. Messvorrichtung (210) nach Anspruch 2, bei welcher die mindestens eine Achse (232, 234) eine von einer vertikalen Achse (232) oder einer horizontalen Achse (234) ist.

4. Messvorrichtung (210) nach einem der obigen Ansprüche, bei welcher das Antennenspeisesystem (260) aus mindestens einem aus einer Vielzahl von Phasenelementen oder Verzögerungselementen (265-1, 265-2, ..., 265-N) besteht, verbunden mit den Strahlerelementen (250-1, 250-2, ..., 250-N), um die Phase der Wellenfront (45) aus der Vielzahl von Strahlererlementen (250-1, 250-2, ..., 250-N) einzustellen.

5. Messvorrichtung (210) nach einem der obigen Ansprüche, bei welcher die Vielzahl der Strahlerelemente in einer linearen Anordnung angeordnet ist.

6. Messvorrichtung (210) nach einem der obigen Ansprüche, bei welcher die Vielzahl der Strahlerelemente in einer zweidimensionalen Anordnung angeordnet ist.

7. Messvorrichtung (210) nach einem der obigen Ansprüche, bei welcher die Speiseantenne (240) etwa doppelt so groß ist wie die Testantenne (220).

8. Verfahren zum Testen einer Testantenne (220) in einer Messvorrichtung (210), umfassend:
Platzieren der Testantenne (220) an einem beweglichen Ständer der Messvorrichtung (210);
Einstellen einer Phase und Amplitude einer Vielzahl von Strahlerelementen (250-1, 250-2, ..., 250-N), die eine Speiseantenne (240) bilden, um eine planare Wellenfront (245) am beweglichen Ständer zu erzeugen, unter Verwendung einer Vielzahl von Einstellkomponenten zum Einstellen der besagten Phase und Amplitude,
wobei die Speiseantenne (240) zwischen 15 und 30 Strahlerelemente umfasst, Abstrahlen eines Testsignals durch die Speiseantenne (240) und
Empfangen des Testsignals durch die Testantenne, um ein Empfangsmuster der Testantenne (220) abzuleiten; und
Wiederholen der Schritte des Abstrahlens des Testsignals und Empfangens des Testsignals für verschiedene Positionen des beweglichen Ständers;
wobei eines der Vielzahl von Strahlerelementen (250-1, 250-2, ..., 250-N) mindestens ein Paar von Strahlerelementen (250-1, 250-2, ..., 250-N) zum Erzeugen von orthogonalen Polarisationskomponenten umfasst,
das Verfahren ferner umfassend Einstellen, durch eine Vielzahl von Abschwächern oder Verstärkungselementen (267-1, 267-2, ..., 267-N), die mit den Strahlerelementen (250) verbunden sind, der Amplitude der Wellenfront (245) aus der Vielzahl von Strahlerelementen (250-1, 250-2, ..., 250-N), wobei das Einstellen umfasst Einstellen einer Leistungsverteilung eingestellt durch die Vielzahl von Abschwächern oder Verstärkungselementen (267-1, 267-2, ..., 267-N) so, dass eine Leistung zumindest in einem mittleren Abschnitt der Speiseantenne (240) konstant ist und an einem Rand der Speiseantenne (240) reduziert ist.

9. Verfahren nach Anspruch 8, ferner umfassend Drehen der Testantenne (220) um eine horizontale Achse (234) und/oder um eine vertikale Achse (232).

10. Verfahren nach einem der Ansprüche 8 und 9, ferner umfassend das Einstellen eines gleichen ersten von mindestens einem von Phase, Verzögerung und Amplitude für eine erste Gruppe von Strahlerelementen und eines gleichen zweiten von mindestens einem von Phase, Verzögerung und Amplitude für eine zweite Gruppe von Strahlerelementen.

## Revendications

1. Appareil de mesure (210) pour la mesure d'une antenne de test (220) comprenant :
un support mobile (230) pour supporter l'antenne de test (220),
une antenne d'alimentation (240) ayant une pluralité d'éléments rayonnants (250-1, 250-2, ..., 250-N),
dans lequel le support mobile (230) est situé à une distance prédéfinie (d) de l'antenne d'alimentation (240) ; et
un système d'alimentation d'antenne (260) ayant une pluralité de composants d'ajustement pour ajuster la phase et l'amplitude d'un front d'onde (245) à partir de la pluralité d'éléments rayonnants (250-1, 250-2, ..., 250-N), de sorte qu'à la distance (d) le front d'onde est plan,
la pluralité d'éléments rayonnants (250-1, 250-2, ..., 250-N) comprend au moins une paire d'éléments rayonnants (250-1, 250-2, ..., 250-N) pour produire des composantes de polarisation orthogonale,
le système d'alimentation d'antenne (260) comporte une pluralité d'atténuateurs ou d'éléments de gain (267-1, 267-2, ..., 267-N) connectés aux éléments rayonnants (250), pour ajuster l'amplitude du front d'onde (245) de la pluralité d'éléments rayonnants (250-1, 250-2, ...250-N), le système d'alimentation d'antenne (260) étant configuré pour ajuster une distribution de puissance définie par la pluralité d'atténuateurs ou d'éléments de gain (267-1, 267-2, ..., 267-N) de telle sorte qu'une puissance soit constante au moins dans une partie centrale de l'antenne d'alimentation (240) et soit réduite au niveau d'un bord de l'antenne d'alimentation (240), dans lequel l'antenne d'alimentation (240) comprend entre 15 et 30 éléments rayonnants.

2. Appareil de mesure (210) selon la revendication 1, dans lequel le support mobile (230) peut tourner autour d'au moins un axe (232, 234).

3. Appareil de mesure (210) selon la revendication 2, dans lequel le au moins un axe (232, 234) est un axe vertical (232) ou un axe horizontal (234).

4. Appareil de mesure (210) selon l'une quelconque des revendications précédentes, dans lequel le système d'alimentation d'antenne (260) comporte au moins un élément parmi une pluralité d'éléments de phase ou d'éléments de retard (265-1, 265-2, ..., 265-N) connectés aux éléments rayonnants (250-1, 250-2, ..., 250-N), pour ajuster la phase du front d'onde (45) de la pluralité d'éléments rayonnants (250-1, 250-2, ..., 250-N).

5. Appareil de mesure (210) de l'une quelconque des revendications précédentes, dans lequel la pluralité d'éléments rayonnants est disposée en un réseau linéaire.

6. Appareil de mesure (210) de l'une quelconque des revendications précédentes, dans lequel la pluralité d'éléments rayonnants est disposée en un réseau bidimensionnel.

7. Appareil de mesure (210) de l'une quelconque des revendications précédentes, dans lequel l'antenne d'alimentation (240) est environ deux fois plus grande que l'antenne de test (220).

8. Procédé pour le test d'une antenne de test (220) dans un appareil de mesure (210) comprenant :
placer l'antenne de test (220) sur un support mobile de l'appareil de mesure (210) ;
ajuster une phase et une amplitude d'une pluralité d'éléments rayonnants (250-1, 250-2, ..., 250-N) formant une antenne d'alimentation (240), pour produire un front d'onde plan (245) au niveau du support mobile,
utiliser une pluralité de composants d'ajustement pour ajuster lesdites phase et amplitude, dans lequel l'antenne d'alimentation (240) comprend entre 15 et 30 éléments rayonnants ;
émettre un signal de test par l'antenne d'alimentation (240), et
recevoir le signal de test par l'antenne de test, afin d'obtenir un diagramme de réception de l'antenne de test (220)
répéter les étapes d'émission et de réception du signal de test pour différentes positions du support mobile ;
dans lequel les éléments de la pluralité d'éléments rayonnants (250-1, 250-2, ..., 250-N) comprennent au moins une paire d'éléments rayonnants (250-1, 250-2, ..., 250-N) pour produire des composantes de polarisation orthogonale,
le procédé comprenant en outre l'ajustement, par une pluralité d'atténuateurs ou d'éléments de gain (267-1, 267-2, ..., 267-N) connectés aux éléments rayonnants (250), de l'amplitude du front d'onde (245) de la pluralité d'éléments rayonnants (250-1, 250-2, ...250-N), dans lequel l'ajustement comprend l'ajustement d'une distribution de puissance définie par la pluralité d'atténuateurs ou d'éléments de gain (267-1, 267-2, ..., 267-N) de telle sorte qu'une puissance soit constante au moins dans une partie centrale de l'antenne d'alimentation (240) et soit réduite au niveau d'un bord de l'antenne d'alimentation (240).

9. Procédé de la revendication 8, comprenant en outre la rotation de l'antenne de test (220) autour d'un axe horizontal (234) et/ou autour d'un axe vertical (232).

10. Procédé selon l'une quelconque des revendications 8 et 9, comprenant en outre le réglage d'une première valeur identique d'au moins une valeur de phase, de retard et d'amplitude pour un premier groupe d'éléments rayonnants et d'une deuxième valeur identique d'au moins une valeur de phase, de retard et d'amplitude pour un deuxième groupe d'éléments rayonnants.
